# FASCICULE DE BREVET EUROPEEN

(11) **EP 3 324 435 B1**
(45) Date de publication et mention de la délivrance du brevet: **14.04.2021**
(21) Numéro de dépôt: 17202210.5
(22) Date de dépôt: 17.11.2017
(51) Int. Cl.: H01L 23/498, H01L 21/48

(54) **PROCEDE DE REALISATION DE VIAS SUR SUBSTRAT FLEXIBLE**
VERFAHREN ZUR HERSTELLUNG VON DURCHGANGSVERBINDUNGEN DURCH EIN FLEXIBLES SUBSTRAT
METHOD FOR PRODUCING VIAS THROUGH A FLEXIBLE SUBSTRATE

(30) Priorité: 21.11.2016 FR 1661300
(43) Date de publication de la demande: 23.05.2018
(73) Titulaire: Commissariat à l'énergie atomique et aux énergies alternatives, 75015 Paris (FR)
(72) Inventeur: BENWADIH, Mohammed, 94500 CHAMPIGNY SUR MARNE (FR); HAON, Olivier, 38960 SAINT ETIENNE DE CROSSEY (FR)
(74) Mandataire: Brevalex

(56) Documents cités:
- EP-A2- 1 035 581
- WO-A1-2006/061589
- US-A1- 2004 061 234

## Description

### DOMAINE TECHNIQUE ET ART ANTÉRIEUR

La présente demande a trait au domaine des circuits réalisés sur un support flexible ou souple, en particulier ceux formés sur un substrat plastique.

Elle concerne plus particulièrement un procédé amélioré de réalisation d'une structure d'interconnexion traversant l'épaisseur d'un support flexible et s'applique notamment dans le cadre de la fabrication de circuits, en particulier RF et/ou électroniques sur de tels types de supports Le document US 2004/061234 décrit des substrats pour un circuit multicouche haute fiabilité et procédés de formation correspondants.

Pour former un élément conducteur traversant l'épaisseur d'un substrat, il est connu de réaliser un trou à l'aide d'un plasma ou d'un laser ou d'une gravure chimique à travers l'ouverture d'un masquage, puis de remplir ce trou à l'aide d'un matériau conducteur. Dans le domaine des circuits réalisés sur un support flexible en matériau élastique notamment en polymère, on utilise typiquement un matériau conducteur sous forme d'encre conductrice liquide pour former des connexions.

Dans de tels dispositifs, le remplissage des trous par de l'encre conductrice liquide peut poser problème. Lorsque le substrat a une épaisseur importante ce remplissage s'avère généralement incomplet, ce qui peut conduire à la mise en œuvre d'élément conducteurs de section transversale inhomogène et qui parfois ne traverse pas entièrement l'épaisseur du substrat et ne débouche donc pas sur les deux faces du support.

Il se pose le problème de trouver un nouveau procédé de réalisation d'interconnexions sur support flexible et qui est amélioré vis-à-vis d'inconvénients mentionnés ci-dessus.

### EXPOSÉ DE L'INVENTION

La présente invention concerne la réalisation améliorée d'une structure de connexion pour substrat flexible ou souple.

Selon un mode de réalisation, elle concerne un procédé comprenant :
- la réalisation d'un ou plusieurs trous traversant l'épaisseur du substrat,
- le dépôt dans le ou les trous d'un premier liquide conducteur ayant une première viscosité,
- le dépôt dans le trou d'un deuxième liquide conducteur ayant une deuxième viscosité supérieure à la première viscosité.

Le premier liquide conducteur et le deuxième liquide conducteur sont typiquement des encres conductrices.

Le premier liquide conducteur a une première viscosité, en particulier une faible viscosité afin de former une couche sur la ou les parois du ou des trous. Cette couche conductrice est destinée à former une gaine conductrice ou portion conductrice périphérique d'éléments conducteurs traversant le substrat. La première viscosité est typiquement comprise entre 0.2 et 100 mPa.s, de préférence entre 10 et 30 mPa.s.

Le deuxième liquide conducteur a une deuxième viscosité plus importante que la première viscosité, en particulier une viscosité élevée afin de permettre de remplir le ou les trous et de former une portion centrale conductrice pour le ou les éléments conducteurs traversant. La deuxième viscosité est typiquement comprise entre 100 et 200000 mPa.s, avantageusement entre 1000 et 40000 mPa.s.

On choisit de préférence le deuxième liquide conducteur et le premier liquide conducteur de sorte que la deuxième viscosité est au moins 10 fois supérieure à la première viscosité et avantageusement entre 50 et 100 fois supérieure à la première viscosité pour remplir des trous de diamètre inférieur à 100 µm. Le rapport entre la deuxième viscosité et la première viscosité peut être prévue de l'ordre de 1000 pour des trous à remplir qui ont un diamètre supérieur à 500 µm.

Le remplissage en deux temps avec des liquides ou encres de viscosités différentes permet d'éviter un bouchage du ou des trous par l'encre conductrice et de permettre que le ou les éléments conducteurs traversent toute l'épaisseur du substrat.

Cela permet également de former une structure d'interconnexion de conductance améliorée.

Le substrat flexible ou souple est en un matériau élastique. On entend par « élastique » un matériau ayant un module d'Young compris entre 10⁻³ GPa et 5 GPa et de préférence au moins 20 fois inférieur à celui du silicium.

Typiquement, le matériau élastique est à base de polymère.

Après formation du ou des trous et préalablement au dépôt de la première encre conductrice, on effectue un traitement de la paroi du trou de sorte à augmenter sa mouillabilité vis-à-vis de la première encre conductrice.

Ce traitement comprend la formation d'une mono-couche auto-assemblée SAM en contact avec la paroi du trou.

La monocouche auto-assemblée (SAM) peut comporter des groupements thiol pour favoriser l'adhésion de la première encre sur la ou les paroi(s) du ou des trou(s).

La mono-couche auto-assemblée SAM peut comporter des groupements silane, amine, ou isocyanate pour favoriser l'adhésion de la mono-couche sur la ou les paroi(s) du ou des trou(s), en particulier lorsque cette paroi est en polymère.

Lorsque le substrat est en matériau polymère, la formation de la couche SAM peut être précédée d'un traitement de sorte à former des groupements hydroxyles sur le polymère. Cela peut permettre de favoriser l'adhérence de la couche SAM sur la paroi du trou.

Le ou les trous peu(ven)t être réalisé(s) de sorte à traverser la première zone conductrice et la deuxième zone conductrice. Cela permet de rendre plus aisée la reprise de contact sur la face inférieure ou supérieure du substrat.

Préalablement à la formation du ou des trou(s), on forme au moins une couche d'encapsulation sur la première zone conductrice et/ou sur la deuxième zone conductrice, le ou les trous étant formé(s) à travers la couche d'encapsulation. Cette ou ces couches d'encapsulation peut ou peuvent servir de masquage au(x) liquide(s) conducteur(s) de remplissage afin de protéger la face du substrat du côté de laquelle s'effectue le remplissage et d'éviter que le liquide conducteur ou l'encre conductrice ne soit déposée sur des régions non-désirées du dispositif.

Avantageusement, le ou les trous est ou sont réalisés par perçage mécanique. Cela permet de ne pas endommager les parois des trous et de favoriser ainsi ultérieurement le traitement ultérieur de ces parois pour permettre d'améliorer leur mouillabilité.

Avantageusement le procédé s'applique à la mise en œuvre de structure d'interconnexions pour un dispositif réalisé sur support flexible et comportant au moins une antenne. La première zone conductrice peut être ainsi une zone du circuit d'antenne tandis que la deuxième zone conductrice peut être une zone d'un plan de masse agencé sur la face arrière du substrat et formant un réflecteur électromagnétique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1H illustrent un exemple de procédé de réalisation d'une structure de connexion traversant un substrat flexible et prévue pour connecter un circuit d'antenne à un plan de masse ;
- les figures 2A-2D illustrent une variante de réalisation du procédé ;
- la figure 3 illustre un agencement d'élément conducteur ayant une portion centrale formée d'une première encre et une portion périphérique formée d'une deuxième encre conductrice de viscosité moins importante que celle de la première encre ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation d'une structure, tels que « avant », « arrière », « supérieure », « inférieure », « latérale » etc. s'appliquent en considérant que la structure est orientée de la façon illustrée sur les figures.

### EXPOSÉ DÉTAILLÉ DE MODES DE RÉALISATION PARTICULIERS

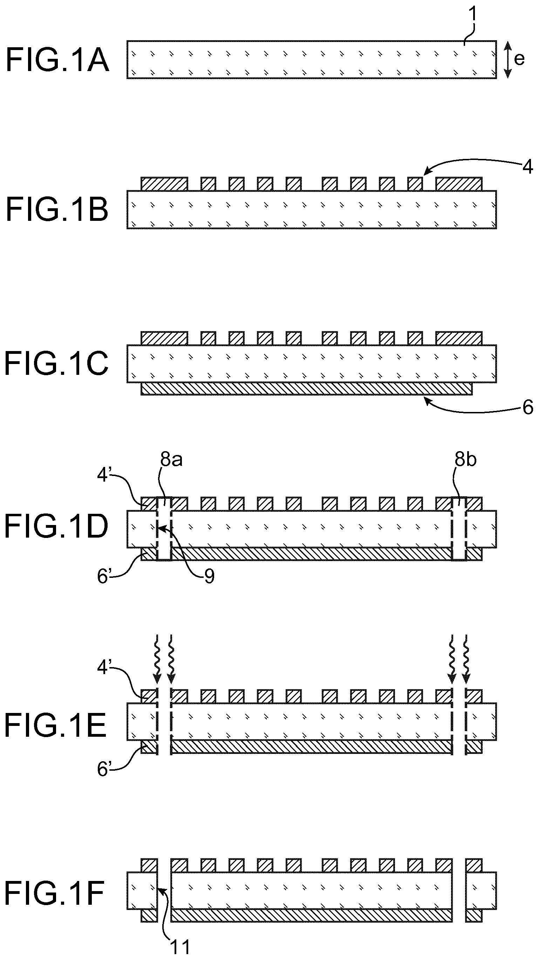

Un exemple de procédé de réalisation d'une structure d'interconnexion sur support flexible tel que mis en œuvre suivant la présente invention, va à présent être donné en liaison avec les figures 1A-1H.

Dans cet exemple, la structure que l'on réalise sert à établir une connexion électrique entre un plan de masse et un circuit d'antenne prévus respectivement sur une première face du support et une deuxième face du support opposée à la première face.

Le support de départ (figure 1A) peut être un substrat 1 souple ou flexible, en particulier de rigidité inférieure à celle de substrats habituellement utilisés en microélectronique. Le substrat flexible est en un matériau élastique typiquement à base de matériau polymère(s) tel que par exemple du polycarbonate (PC), du polyéthylène (PE), du polyimide (PI). Le substrat 1 a une épaisseur e qui peut être comprise par exemple entre 10 µm et 7 mm, de préférence supérieure à 50 µm. Selon un exemple particulier, on utilise un substrat flexible en polycarbonate d'épaisseur de l'ordre de 250 µm et de 175µm.

On forme tout d'abord sur une face supérieure du substrat 1 encore appelée « face avant » un ensemble de pistes conductrices 4 formant un circuit d'antenne (figure 1B). On réalise également sur une face inférieure du substrat 1 encore appelée « face arrière », et qui est opposée à la face avant, au moins une zone conductrice 6 appelée « plan de masse » (figure 1C). Cette zone conductrice 6 sert de référence des potentiels électriques du circuit d'antenne et peut également remplir la fonction de réflecteur électromagnétique.

Les pistes conductrices 4 et la zone conductrice 6 peuvent être réalisées par dépôt d'au moins une encre liquide conductrice par exemple par le biais de technique de sérigraphie, ou par jet d'encre. L'encre conductrice comprend typiquement un solvant un liant et des particules conductrices, par exemple métalliques, et à base d'Ag ou de Ni ou d'Au, ou de Cu ou de Pd ou de Pt.

On réalise ensuite un ou plusieurs trous 8a, 8b traversant l'épaisseur du substrat 1. Dans l'exemple illustré sur la figure 1D, les trous 8a, 8b sont formés de sorte à traverser chacun au moins une piste conductrice 4' de la face supérieure et ainsi qu'au moins une portion conductrice 6' du plan de masse.

Les trous 8a, 8b peuvent avoir une largeur W (plus petite dimension mesurée dans un plan parallèle au plan [0 ; x ;y ] du repère [0 ; x ;y ; z], le plan [0 ; x ;y] étant lui-même parallèle à la face supérieure de la deuxième couche) comprise par exemple entre 1 et 500 µm et une hauteur H (dimension mesurée parallèlement à l'axe z) correspondant à l'épaisseur du substrat. H est comprise par exemple entre 1 et 7mm, et par exemple de l'ordre de 175 µm ou de 250 µm dans le cas d'un substrat en polycarbonate tel qu'évoqué précédemment. Les trous 8a, 8b traversant peuvent être ainsi réalisés avec un rapport de forme W/H compris par exemple 10 et 10⁻⁴.

Dans le cas d'un substrat 1 en matériau polymère une gravure chimique peut s'avérer difficile à mettre en œuvre, en particulier dans le cas où le polymère est du polycarbonate. Des procédés de gravure par laser ou par plasma peuvent s'avérer longs à mettre en œuvre et engendrer une détérioration des parois des trous lorsque le substrat 1 est en matériau polymère.

Pour éviter les problèmes mentionnés ci-dessus, la gravure des trous 8a, 8b peut être réalisée mécaniquement, typiquement à l'aide d'une perceuse dotée de micro-forets de diamètre de l'ordre de un à plusieurs micromètres ou dizaines de micromètres. Par exemple, on peut employer un foret de diamètre de 50 µm, ou de 80 µm, ou de 100 µm, ou de 150 µm, ou de 250 µm. Le perçage mécanique des trous 8a, 8b permet de ne pas endommager leur paroi 9 qui s'étend dans toute l'épaisseur du substrat 1.

La perceuse utilisée peut être reliée à une unité de commande numérique ou à un circuit de commande permettant de piloter le déplacement du forêt en fonction de données de position ou de coordonnées déterminées en fonction de l'agencement du dispositif dans lequel on réalise la structure d'interconnexion. Dans cet exemple, les données de positions sont établies en fonction du positionnement d'éléments du circuit d'antenne et du plan de masse.

Après formation des trous 8a, 8b et préalablement à leur remplissage pour former des éléments conducteurs, on effectue une ou plusieurs étapes de traitement des parois 9 des trous 8a, 8b de sorte à augmenter leur mouillabilité vis-à-vis de liquides conducteurs de remplissage destinés à être déposés dans les trous, en particulier d'encres comportant des particules conductrices typiquement métalliques.

Un premier traitement peut être prévu de sorte à former des groupements hydroxyles (-OH) sur les parois 9 respectives des trous. Cela peut être réalisé par plasma, par exemple de type RIE sous oxygène O₂ avec une pression comprise entre 10 et 150 mTorr, une puissance comprise par exemple entre 20 et 200 Watt, pendant une durée qui peut être prévue entre 1 et 10 minutes. De préférence, on effectue ce premier traitement par le biais d'un équipement de traitement de surface utilisant un rayonnement UV et-une atmosphère d'Ozone. La durée de l'exposition au rayonnement UV peut être par exemple comprise entre 20 et 600 secondes (figure 1E). On peut également effectuer un tel traitement à l'aide d'une solution aqueuse par exemple de type NaBH₄ dans l'eau.

Un deuxième traitement peut être ensuite prévu de sorte à former une couche 11 SAM (SAM pour « Self Assembled Monolayer » ou mono-couche auto assemblée) sur les parois 9 des trous 8a, 8b afin d'augmenter l'adhérence au niveau des parois d'encre(s) conductrice(s) amenée(s) à être déposée(s) dans les trous 8a, 8b (figure 1F).

La couche SAM comporte typiquement des groupements de type silane ou amine ou isocyanate pour permettre de faire adhérer cette couche au matériau du substrat 1 en polymère(s). Afin de permettre d'améliorer la capillarité du liquide conducteur sur les parois des trous 8a, 8b, La couche 11 SAM comporte également typiquement des groupements de type thiol, en particulier lorsque le liquide conducteur amené à être déposé est une encre conductrice à base de particules d'Ag ou de Cu ou de Ni.

La couche 11 SAM peut être par exemple une couche de 4-nitrobenzenethiol ou de (3-Mercaptopropyl) trimethoxysilane.

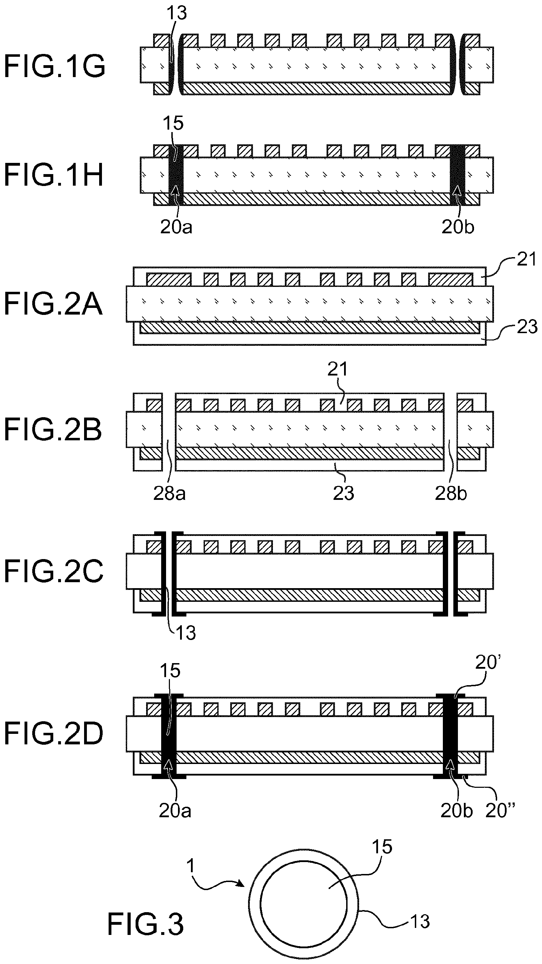

On forme ensuite une fine couche conductrice sur les parois 9 des trous 8a, 8b, par dépôt d'un liquide conducteur, en particulier une encre conductrice 13 (figure 1G). Cette encre conductrice 13 présente une viscosité faible qui peut être comprise par exemple entre 0.2 et 100 centipoise (autrement dit mPa.s), de préférence entre 10 et 30 mPa.s.

L'encre conductrice 13 peut être à base de particules de métal choisies par exemple parmi Ag, Ni, Au, Cu, Pd, Pt dans un solvant. Selon un exemple particulier on emploie une encre conductrice 13 à base de nanoparticule d'argent, par exemple de l'ordre de 20% maximum en poids, dilué dans un alcool de type « Cabot Conductive Ink CCI-300 » commercialisée par la société CABOT corporation présentant une viscosité comprise entre 11 et 15 cP. Une autre encre commerciale peut être également utilisée comme encre conductrice à base de nanoparticules d'argent 13 commercialisée par la société Advanced nano Products ANP DGP 40LT-15. Une telle encre présente une viscosité qui peut être de l'ordre de 13 cP et peut être diluée dans un solvant de type Triéthylène glycol monoéthyl éther, la concentration en poids d'argent pouvant être comprise entre 30 et 35% d'argent.

Un recuit thermique, par exemple à une température de l'ordre de 60°C pendant 1 minute est ensuite effectué suivie d'un recuit de 100°C pendant 5 minutes afin de faire sécher l'encre et former une fine couche conductrice sur les parois 9.

Ensuite, on dépose dans les trous 8a, 8c, une autre encre conductrice 15 ayant cette fois une viscosité plus élevée que celle de l'encre conductrice 13 (figure 1H).

L'autre encre conductrice 15, plus visqueuse a typiquement une viscosité comprise entre 100 et 200000 centipoise cP (autrement dit mPa.s), de préférence entre 5000 et 40000 mPa.s. L'autre encre conductrice 15 peut être également à base de particules de métal choisies par exemple parmi Ag, Ni, Au, Cu, Pd, Pt et contenir un épaississant tel que par exemple de la cellulose. Selon un exemple particulier on emploie une encre conductrice 15 de type LOCTITE® ECI 1006 E&C commercialisée par la société Henkel ou aussi l'encre HPS021 ou FG32 commercialisée par la société NOVACENTRIX.

L'emploi d'une encre 15 plus visqueuse permet cette fois un remplissage de la partie centrale des trous 8a, 8b. On forme ainsi des éléments conducteurs. Un recuit thermique, par exemple à une température de l'ordre de 130°C pendant 30 minutes est ensuite effectué afin de faire sécher l'encre 15 et former une portion centrale conductrice dans les trous 8a, 8b.

En effectuant le remplissage des trous 8a, 8b en deux temps en utilisant tout d'abord une encre 13 fluide puis une encre 15 de viscosité plus importante, on obtient une répartition plus homogène de matériau conducteur dans les trous 8a, 8b et un meilleur remplissage de ces derniers.

On forme ainsi des éléments conducteurs 20a, 20b conducteurs traversant l'épaisseur du substrat 1 et en contact chacun avec une portion conductrice 4' du circuit d'antenne disposée sur la face supérieure et une zone conductrice 6' disposée sur la face inférieure. Les éléments conducteurs 20a, 20b permettant d'établir une connexion entre face inférieure et face supérieure du substrat 1 ont une section transversale homogène et une conductance améliorée.

Selon une variante du procédé de réalisation décrit précédemment, on peut prévoir de former une couche d'encapsulation sur la face supérieure et/ou sur la face inférieure du substrat 1.

Dans l'exemple illustré sur la figure 2A, préalablement à la réalisation des trous, on forme sur la face supérieure du substrat 1 une première couche d'encapsulation 21 permettant de réaliser une protection du circuit d'antenne, tandis qu'une deuxième couche d'encapsulation 23 est déposée sur la face inférieure du substrat 1, et permet de protéger le plan de masse.

Les couches d'encapsulation 21, 23 peuvent être à base d'un polymère, par exemple un polyimide et peut avoir des propriétés adhésives, tel que par exemple le Kapton®. Avantageusement, les couches d'encapsulation sont à base de fluoro-polymère.

Ensuite on forme des trous 28a, 28b traversant les couches d'encapsulation 21, 23 et l'épaisseur du substrat 1 (figure 2B). Cela peut être réalisé par exemple à l'aide d'un perçage tel que décrit précédemment en liaison avec la figure 1D.

Puis, après avoir de préférence réalisé une préparation de surface des parois des trous 28a, 28b du type de celle décrite précédemment en lien avec les figures 1E-1F, on effectue un premier dépôt d'encre conductrice 13 de faible viscosité (figure 2C), de sorte à former une gaine ou zone conductrice périphérique d'éléments conducteurs sur la paroi latérale des trous 28a, 28b.

Lors de ce dépôt, les couches d'encapsulation 21, 23 servent de masque de protection pour empêcher un dépôt intempestif d'encre conductrice 13 sur des zones non-désirées de la face supérieure et de la face inférieure du substrat 1. On empêche ainsi que l'encre conductrice ne vienne s'étaler sur le circuit d'antenne ou le plan de masse, ce qui pourrait conduire le cas échéant à la formation de court-circuit. Avantageusement, lorsque la couche d'encapsulation 21 est à base d'un polymère de type fluoro-polymère permettant de favoriser le démouillage de l'encre 13 conductrice sur la face supérieure et du substrat 1. Cela participe à un meilleur remplissage d'encre conductrice 13 dans les trous 28a, 28b.

Ensuite, on effectue un dépôt de l'autre encre conductrice 15 de viscosité plus importante que celle de l'encre conductrice 13 (figure 2D). Cet autre remplissage permet de former une portion conductrice centrale pour des éléments conducteurs 20a, 20b traversant le substrat 1.

Un agencement avec une portion conductrice centrale formée de l'encre conductrice 15 visqueuse et une gaine formée de l'encre conductrice 13 moins visqueuse est illustré sur la figure 3 donnant une vue en coupe d'un élément conducteur formé à travers le substrat 1 souple.

Afin de permettre une prise de contact plus aisée, les éléments conducteurs 20a, 20b peuvent comporter une ou plusieurs régions conductrices 20', 20" s'étendant respectivement sur les couches d'encapsulation 21, 23 sans toutefois créer de court-circuit.

Dans l'un ou l'autre des exemples de procédés qui viennent d'être décrits, on crée une structure d'interconnexion pour un circuit d'antenne. Un procédé suivant l'invention peut également s'appliquer à la mise en œuvre de dispositifs dotés d'autre types circuit électroniques sur support flexible.

## Revendications

1. Procédé de réalisation d'une structure de connexion traversant un substrat (1) flexible pour connecter au moins une première zone conductrice (4') disposée sur une première face du substrat (1) et au moins au moins une deuxième zone conductrice (6') disposée sur une deuxième face du substrat, comprenant :
- réaliser au moins un trou (8a, 8b, 28a, 28b) traversant l'épaisseur (e) d'un substrat flexible,
- dépôt dans le trou d'une première encre conductrice (13) ayant une première viscosité, de sorte à former une couche conductrice sur une paroi (9) du trou, la couche conductrice formant une portion conductrice périphérique d'un élément conducteur,
- dépôt dans le trou d'une deuxième encre conductrice (15) ayant une deuxième viscosité supérieure à la première viscosité, de sorte à réaliser une portion conductrice centrale de l'élément conducteur (20a, 20b),
le procédé comprenant après formation du trou (8a, 8b, 28a, 28b) et préalablement au dépôt de la première encre conductrice (13), un traitement de la paroi (9) du trou de sorte à augmenter sa mouillabilité vis-à-vis de la première encre conductrice, le traitement comprenant la formation d'une mono-couche auto-assemblée SAM en contact avec la paroi du trou.

2. Procédé selon la revendication 1, dans lequel le substrat (1) est en matériau polymère et la première encre (13) est à base de particules métalliques, la monocouche auto-assemblée (SAM) comportant des groupements thiol pour favoriser l'adhésion de la première encre (13), la mono-couche auto-assemblée SAM comportant des groupements silane, amine isocyanate pourfavoriser l'adhésion de la mono-couche sur le matériau polymère du substrat (1).

3. Procédé selon l'une des revendications 1 ou 2, dans lequel le substrat (1) est en matériau polymère, la formation de la mono-couche étant précédé d'un traitement de sorte à former des fonctions hydroxyles sur le polymère.

4. Procédé selon l'une des revendications 1 à 3, dans lequel ledit au moins un trou (8a, 8b, 28a, 28b) est réalisé de sorte à traverser la première zone conductrice et la deuxième zone conductrice.

5. Procédé selon l'une des revendications 1 à 4, dans lequel préalablement à la formation dudit au moins un trou (28a, 28b), on forme au moins une couche d'encapsulation (21, 23) sur la première zone conductrice et/ou sur la deuxième zone conductrice, ledit au moins un trou étant formé à travers la couche d'encapsulation.

6. Procédé selon l'une des revendications 1 à 5, dans lequel ledit au moins un trou est réalisé par perçage mécanique.

7. Procédé selon l'une des revendications 1 à 6, dans lequel la première viscosité est comprise entre 0.2 et 100 mPa.s, la deuxième viscosité est comprise entre 100 et 200000 mPa.s et au moins 10 fois supérieure à la première viscosité.

8. Procédé selon l'une des revendications 1 à 7, dans lequel la première zone conductrice est une zone d'un circuit d'antenne agencée sur la face avant du substrat, la deuxième zone conductrice étant une zone d'un plan de masse agencé sur la face arrière du substrat et formant un réflecteur.

## Patentansprüche

1. Verfahren zum Herstellen einer durch ein flexibles Substrat (1) hindurchgehenden Verbindungsstruktur zum Verbinden zumindest eines auf einer ersten Seite des Substrats (1) angeordneten ersten leitfähigen Bereichs (4') und zumindest eines auf einer zweiten Seite des Substrats angeordneten zweiten leitfähigen Bereichs (6'), umfassend:
- Herstellen von zumindest einem Loch (8a, 8b, 28a, 28b), das durch die Dicke (e) eines flexiblen Substrats hindurchgeht,
- Aufbringen einer ersten leitfähigen Tinte (13) mit einer ersten Viskosität in das Loch, um eine leitfähige Schicht auf einer Wand (9) des Lochs zu bilden, wobei die leitfähige Schicht einen leitfähigen Umfangsabschnitt eines leitfähigen Elements bildet,
- Aufbringen einer zweiten leitfähigen Tinte (15) mit einer zweiten Viskosität, die höher als die erste Viskosität ist, in das Loch, um einen leitfähigen Mittelabschnitt des leitfähigen Elements (20a, 20b) auszubilden,
wobei das Verfahren nach dem Bilden des Lochs (8a, 8b, 28a, 28b) und vor dem Aufbringen der ersten leitfähigen Tinte (13) eine Behandlung der Wand (9) des Lochs umfasst, um ihre Benetzbarkeit in Bezug auf die erste leitfähige Tinte zu erhöhen, wobei die Behandlung die Bildung einer selbstorganisierenden Monoschicht SAM in Kontakt mit der Wand des Lochs umfasst.

2. Verfahren nach Anspruch 1, wobei das Substrat (1) aus polymerem Material besteht und die erste Tinte (13) auf Metallpartikeln basiert, wobei die selbstorganisierende Monoschicht (SAM) Thiolgruppen enthält, um die Haftung der ersten Tinte (13) zu fördern, wobei die selbstorganisierende Monoschicht (SAM) Silan-, Amin- bzw. Isocyanatgruppen enthält, um die Haftung der Monoschicht an dem polymeren Material des Substrats (1) zu fördern.

3. Verfahren nach einem der Ansprüche 1 oder 2, wobei das Substrat (1) aus polymerem Material besteht, wobei der Bildung der Monoschicht eine Behandlung vorausgeht, um Hydroxylfunktionen auf dem Polymer zu bilden.

4. Verfahren nach einem der Ansprüche 1 bis 3, wobei das zumindest eine Loch (8a, 8b, 28a, 28b) so hergestellt wird, dass es durch den ersten leitfähigen Bereich und durch den zweiten leitfähigen Bereich hindurchgeht.

5. Verfahren nach einem der Ansprüche 1 bis 4, wobei vor der Bildung des zumindest einen Lochs (28a, 28b) zumindest eine Einkapselungsschicht (21, 23) auf dem ersten leitfähigen Bereich und/oder auf dem zweiten leitfähigen Bereich gebildet wird, wobei das zumindest eine Loch durch die Einkapselungsschicht hindurch gebildet wird.

6. Verfahren nach einem der Ansprüche 1 bis 5, wobei das zumindest eine Loch durch mechanisches Bohren hergestellt wird.

7. Verfahren nach einem der Ansprüche 1 bis 6, wobei die erste Viskosität zwischen 0,2 und 100 mPa.s liegt und die zweite Viskosität zwischen 100 und 200.000 mPa.s liegt und zumindest 10-mal größer als die erste Viskosität ist.

8. Verfahren nach einem der Ansprüche 1 bis 7, wobei der erste leitfähige Bereich ein Bereich eines auf der Vorderseite des Substrats angeordneten Antennenschaltkreises ist, wobei der zweite leitfähige Bereich ein Bereich einer auf der Rückseite des Substrats angeordneten, einen Reflektor bildenden Massefläche ist.

## Claims

1. A method for producing a connection structure passing through a flexible substrate (1) to connect at least a first conductive zone (4') arranged on a first face of the substrate (1) and at least a second conductive zone (6') arranged on a second face of the substrate, comprising:
- producing at least a hole (8a, 8b, 28a, 28b) passing through the thickness (e) of a flexible substrate,
- depositing in the hole a first conductive ink (13) having a first viscosity, so as to form a conductive layer on a wall (9) of the hole, the conductive layer forming a peripheral conductive portion of a conductive element,
- depositing in the hole a second conductive ink (15) having a second viscosity greater than the first viscosity, so as to produce a central conductive portion of the conductive element (20a, 20b),
the method comprising, after formation of the hole and prior to the deposition of the first conductive ink, a treatment of the wall of the hole so as to increase its wettability vis-à-vis the first conductive ink, the treatment comprises the formation of a self-assembled monolayer SAM in contact with the wall of the hole.

2. The method according to claim 1, wherein the substrate (1) is made of polymer material and the first ink (13) is based on metal particles, the self-assembled monolayer (SAM) comprising thiol groups to favour the adhesion of the first ink (13), the self-assembled monolayer SAM comprising silane, amine, isocyanate groups to favour the adhesion of the mono-layer on the polymer material of the substrate.

3. The method according to any of the claims 1 or 2, wherein the substrate (1) is made of polymer material, the formation of the mono-layer being preceded by a treatment so as to form hydroxyl functions on the polymer.

4. The method according to any of the claims 1 to 3, wherein said hole (8a, 8b, 28a, 28b) is produced so as to pass through the first conductive zone and the second conductive zone.

5. The method according to any of the claims 1 to 4, wherein prior to the formation of said hole (28a, 28b), at least one encapsulation layer (21, 23) is formed on the first conductive zone and/or on the second conductive zone, said hole being formed through the encapsulation layer.

6. The method according to any of the claims 1 to 5, wherein said hole is produced by mechanical drilling.

7. The method according to any of the claims 1 to 6, wherein the first viscosity is comprised between 0.2 and 100 mPa.s, the second viscosity is comprised between 100 and 200,000 mPa.s and is at least 10 times greater than the first viscosity.

8. The method according to any of the claims 1 to 7, wherein the first conductive zone is a zone of an antenna circuit arranged on the front face of the substrate, the second conductive zone being a zone of a ground plane arranged on the rear face of the substrate and forming a reflector.
